# FASCICULE DE BREVET EUROPEEN

(11) **EP 2 759 051 B1**
(45) Date de publication et mention de la délivrance du brevet: **14.10.2015**
(21) Numéro de dépôt: 12759754.0
(22) Date de dépôt: 20.09.2012
(51) Int. Cl.: H02M 7/797, H02J 3/36

(54) **PROCEDE D'OUVERTURE D'INTERRUPTEUR DE DERIVATION DE RESEAU A COURANT CONTINU HAUTE TENSION**
VERFAHREN ZUM ÖFFNEN EINER BYPASS-SCHALTUNG EINES HOCHSPANNUNGSGLEICHSTROMNETZES
METHOD OF OPENING A BYPASS SWITCH OF A HIGH VOLTAGE DIRECT CURRENT NETWORK

(30) Priorité: 21.09.2011 FR 1158379
(43) Date de publication de la demande: 30.07.2014
(73) Titulaire: ALSTOM Technology Ltd, 5400 Baden (CH)
(72) Inventeur: GRIESHABER, Wolfgang, 69006 Lyon (FR); DUPRAZ, Jean-Pierre, F-01360 Bressolles (FR)
(74) Mandataire: Ahner, Philippe
(86) Numéro de dépôt international: PCT/EP2012/068529
(87) Numéro de publication internationale: WO 2013/041614

(56) Documents cités:
- EP-A1- 1 986 316
- EP-A2- 1 037 372
- JP-A- 2000 050 498

## Description

### Domaine technique et art antérieur

L'invention concerne un procédé d'ouverture d'interrupteur de dérivation de réseau à courant continu haute tension.

Un exemple de réseau à courant continu haute tension de l'art antérieur est connu du document WO 2007/084041 au JP 2000 0504 98. Ce réseau est représenté en figure 1. Il comprend une ligne de transmission bifilaire 1 constituée d'une partie la reliée à la haute tension et d'une partie 1b reliée au potentiel zéro. Un premier convertisseur 2 est connecté, à une première extrémité de la ligne 1, entre la partie la et la partie 1b. A la deuxième extrémité de la ligne 1, opposée à la première extrémité, un deuxième convertisseur 3 est également connecté entre la partie 1a et la partie 1b. Le premier convertisseur 2 comprend deux blocs de thyristors en série 4, 5, chaque bloc de thyristors comprenant trois thyristors en parallèle. De même, le deuxième convertisseur 3 comprend deux blocs de thyristors en série 6, 7, chaque bloc de thyristors comprenant trois thyristors en parallèle. Chacun des thyristors des blocs 4, 5, 6, 7 de trois thyristors est associé à une phase différente. Un interrupteur de dérivation est monté en parallèle de chaque bloc de thyristors, à savoir :
- l'interrupteur 8 en parallèle du bloc de thyristors 4,
- l'interrupteur 9 en parallèle du bloc de thyristors 5,
- l'interrupteur 10 en parallèle du bloc de thyristors 6, et
- l'interrupteur 11 en parallèle du bloc de thyristors 7.

Le convertisseur 2 est relié à un réseau générateur de courant alternatif 12 et le convertisseur 3 est relié à un réseau de consommation de courant alternatif 13. Le premier convertisseur 2 fonctionne en convertisseur alternatif/continu (redresseur) et le deuxième convertisseur 3 fonctionne en convertisseur continu/alternatif.

Les blocs de thyristors 4 et 5, de même que les interrupteurs 8 et 9, sont commandés par les unités de contrôle respectives 14 et 15. Les blocs de thyristros 6 et 7, de même que les interrupteurs 10 et 11, sont commandés par les unités de contrôle respectives 16 et 17. Des dispositifs de commande 18 et 19 pilotent les unités de contrôle 14, 15, 16 et 17.

En cas de défaillance du système, il peut arriver qu'il soit nécessaire de court-circuiter un bloc de thyristors, par exemple le bloc de thyrsistors 4. L'ensemble des thyristors du bloc 4 sont alors court-circuités par la fermeture de l'interrupteur de dérivation 8. Simultanément, les thyristors du bloc 6 doivent également être court-circuités par la fermeture de l'interrupteur de dérivation 10. La puissance transmise sur la ligne 1 s'en trouve diminuée, mais le système continue tout de même à fonctionner en mode dégradé. Une fois le sytème réparé, les interrupteurs de dérivation 8 et 10 doivent être à nouveau ouverts afin que le courant puisse circuler dans les blocs de thyristors 4 et 6.

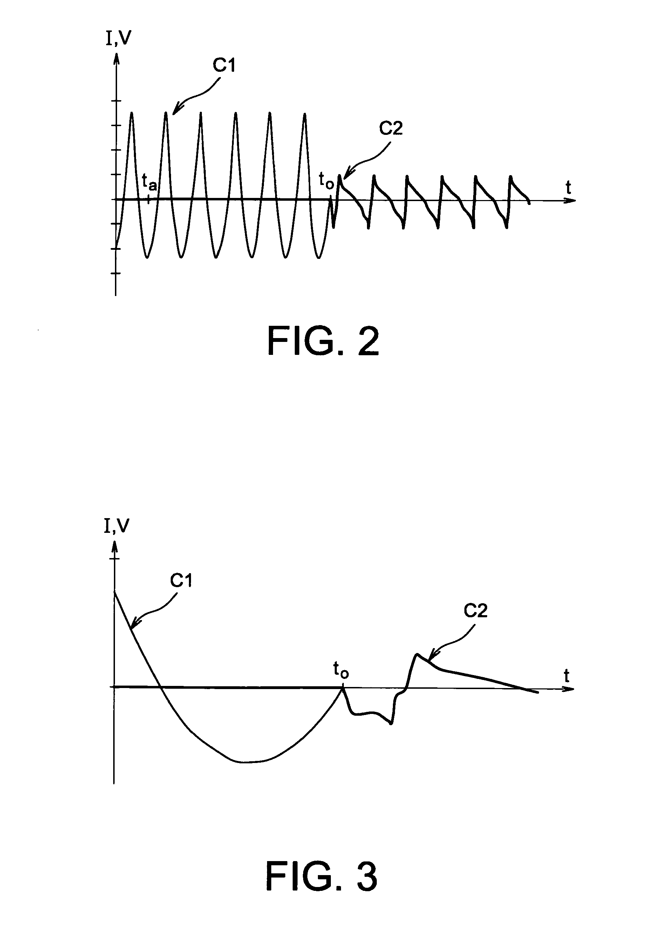

Les figures 2 et 3 illustrent le phénomème d'ouverture d'un interrupteur de dérivation selon l'art antérieur. La figure 3 est une vue zoomée de la figure 2. La courbe C1 des figures 2 et 3 représente le courant I qui parcourt l'interrupteur en fonction du temps et la courbe C2 représente la tension V aux bornes de l'interrupteur en fonction du temps. La courbe C1 prend une valeur nulle à l'instant t₀ et aux instants supérieurs à t₀ et la courbe C2 prend une valeur nulle à l'instant t₀ et aux instants inférieurs à t₀.

Le courant I qui circule dans l'interrupteur est ajusté pour avoir une valeur moyenne nulle au moment de l'ouverture de l'interrupteur de dérivation. Ce courant de valeur moyenne nulle correspond à un angle de contrôle de thyristor sensiblement égal à 90°. Comme cela est connu de l'homme de l'art, l'angle de contrôle d'un thyristor est, par définition, le déphasage entre l'instant où la différence de potentiel à laquelle est soumis le thyristor rend celui-ci potentiellement apte à conduire du courant s'il en recevait l'ordre et l'instant auquel un ordre de conduction est réellement donné au thyristor.

Pour un ordre d'ouverture de l'interrupteur donné à un instant tₐ, la coupure du courant s'effectue à un instant t₀ ultérieur à tₐ qui correspond à un passage par zéro du courant. Sur les figures 2 et 3, la coupure du courant s'effectue sur le front montant de la courbe de courant. Il est également possible toutefois que la coupure du courant se produise sur le front descendant de la courbe de courant.

Comme cela apparaît sur les figures 2 et 3, lors de la coupure du courant de l'interrupteur, il apparaît, sur une durée très courte, une forte surtension aux bornes de l'interrupteur. Ceci représente un inconvénient. En effet, la forte montée en tension aux bornes de l'interrupteur est susceptible d'entraîner l'apparition d'un arc électrique (claquage de l'interrupteur) qui endommage le matériel (percemment de pièces diélectriques).

L'invention ne présente pas cet inconvénient.

### Exposé de l'invention

En effet, l'invention concerne un procédé d'ouverture d'interrupteur de dérivation parcouru par un courant, l'interrupteur étant monté en parallèle d'au moins un thyrsitor de réseau à courant continu haute tension, une coupure du courant qui parcourt l'interrupteur étant déclenchée lors d'un zéro de courant du courant qui parcourt l'interrupteur, caractérisé en ce qu'il comprend, sur la base d'une mesure effectuée par des moyens de mesure du courant qui parcourt l'interrupteur, une étape de réglage d'un angle de contrôle du thyristor pour positionner le zéro de courant dans une zone où la dérivée par rapport au temps du courant mesuré est une fonction continue et où la valeur absolue d'une valeur crête du courant mesuré est sensiblement égale à la valeur absolue de l'imprécision de mesure du zéro de courant.

Selon une caractéristique supplémentaire de l'invention, pendant une durée qui précède l'ouverture de l'interrupteur et durant laquelle le courant ne présente jamais de zéro de courant et a une valeur absolue qui reste supérieure à la valeur du courant d'arrachement de l'interrupteur, une commande d'ouverture est appliquée à l'interrupteur à un premier instant et, simultanément, une étape de réglage de l'angle de contrôle est déclenchée pour rapprocher de zéro des valeurs crête du courant de telle sorte qu'à un deuxième instant, ultérieur au premier instant, des contacts de l'interrupteur soient séparés d'une distance sensiblement prédéfinie apte à permettre à l'interrupteur de tenir une tension de rétablissement.

Selon encore une caractéristique supplémentaire de l'invention, une étape de mesure de la distance qui sépare les contacts de l'interrupteur est déclenchée au premier instant et, au deuxième instant, une étape de réglage supplémentaire de l'angle de contrôle est déclenchée pour amener le courant dans la zone où la dérivée par rapport au temps du courant mesuré est une fonction continue et où la valeur absolue d'une valeur crête du courant mesuré est sensiblement égale à la valeur absolue de l'imprécision de mesure du zéro de courant.

Selon encore une autre caractéristique supplémentaire de l'invention, le deuxième instant est déclenché à l'aide d'un dispositif de temporisation et, au deuxième instant, une étape de réglage supplémentaire de l'angle de contrôle est déclenchée pour amener le courant dans la zone où la dérivée par rapport au temps du courant mesuré est une fonction continue et où la valeur absolue d'une valeur crête du courant mesuré est sensiblement égale à la valeur absolue de l'imprécision de mesure du zéro de courant.

Selon encore une autre caractéristique supplémentaire de l'invention, le deuxième instant est déclenché à l'aide d'un indicateur de dépassement de position lorsque la distance entre contacts atteint une distance sensiblement prédéfinie et, au deuxième instant, une étape de réglage supplémentaire de l'angle de contrôle est déclenchée pour amener le courant dans la zone où la dérivée par rapport au temps du courant mesuré est une fonction continue et où la valeur absolue d'une valeur crête du courant mesuré est sensiblement égale à la valeur absolue de l'imprécision de mesure du zéro de courant.

### Brève description des figures

D'autres caractéristiques et avantages de l'invention apparaîtront à la lumière de la description qui va suivre, faite en référence aux figures jointes parmi lesquelles :
- la figure 1, déjà décrite, représente un exemple de réseau à courant continu haute tension de l'art antérieur ;
- les figures 2 et 3, déjà décrites, illustrent le phénomème d'ouverture d'un interrupteur de dérivation selon l'art antérieur ;
- la figure 4 représente un exemple de réseau à courant continu haute tension de l'invention ;
- les figures 5, 6 et 7A-7C illustrent le procédé d'ouverture d'un interrupteur de dérivation selon l'invention ;
- les figures 8 et 9 illustrent un perfectionnement du procédé d'ouverture d'un interrupteur de dérivation selon l'invention.

Sur toutes les figures, les mêmes références désignent les mêmes éléments.

### Exposé détaillé de modes de réalisation particuliers de l'invention

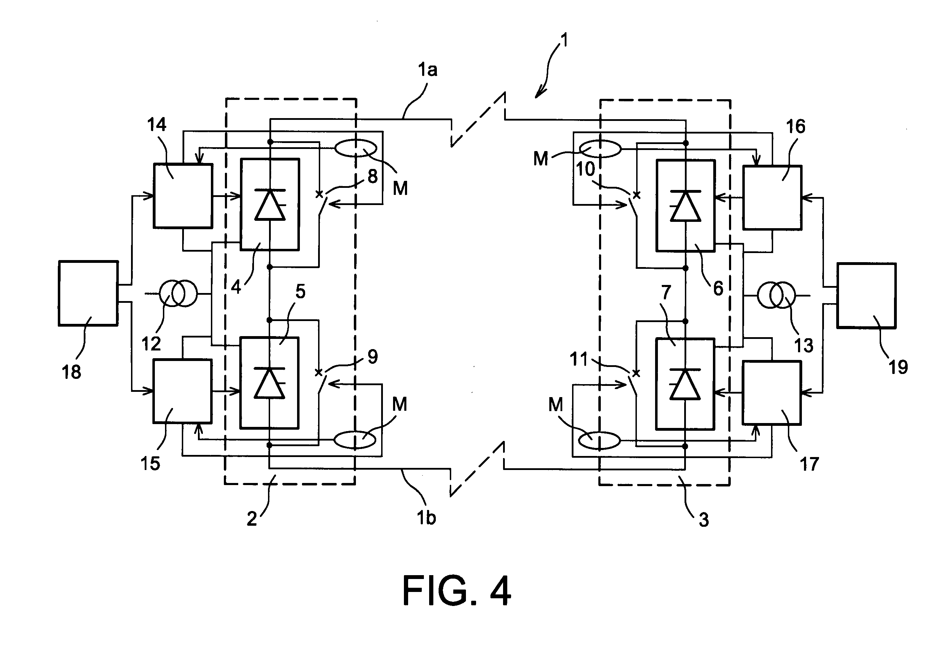

La figure 4 représente un exemple de réseau à courant continu haute tension de l'invention.

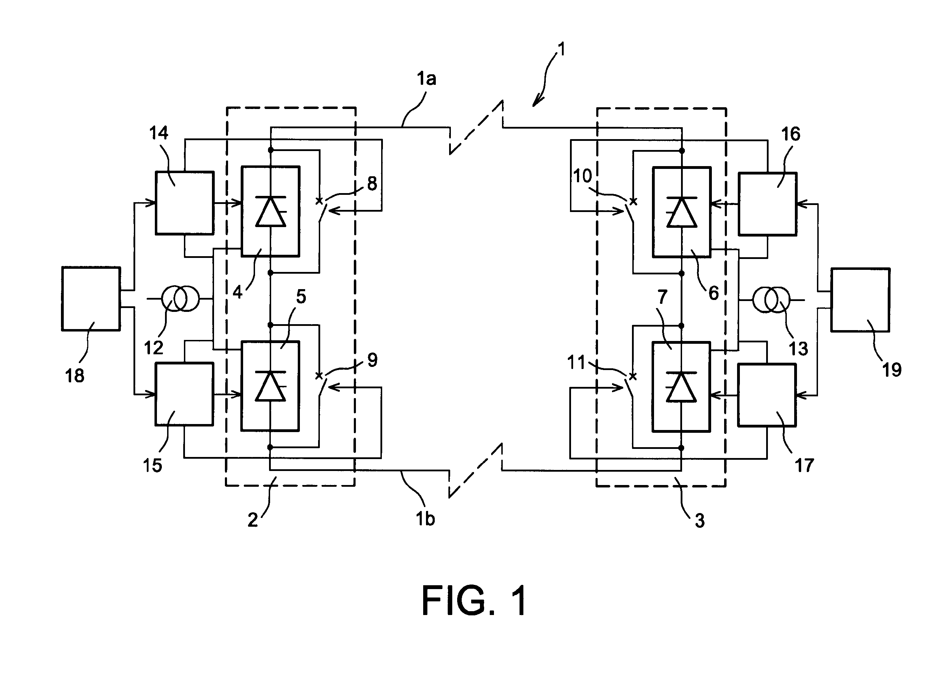

En plus des éléments représentés en figure 1, le réseau à courant continu haute tension de l'invention comprend des moyens de mesure de courant M qui mesurent le courant I qui circule dans chacun des interrupteurs 8, 9, 10 et 11. Par ailleurs, le réseau à courant continu haute tension de l'invention comprend des moyens aptes à déterminer la dérivée du courant mesuré par rapport au temps. Dans un premier mode de réalisation de l'invention, les moyens aptes à déterminer la dérivée du courant mesuré par rapport au temps sont des moyens de calcul qui appartiennent aux unités de contrôles 14, 15, 16, 17 et qui calculent la dérivée du courant par rapport au temps à partir des mesures de courant. Dans un deuxième mode de réalisation de l'invention, les moyens aptes à déterminer la dérivée du courant mesuré par rapport au temps comprennent des bobines de Rogowski qui sont parcourues par le courant mesuré. Les bobines de Rogowski mesurent, par induction, une tension proportionnelle à la variation du courant par rapport au temps. Ces mesures sont alors transmises aux unités de contrôle 14, 15, 16, 17.

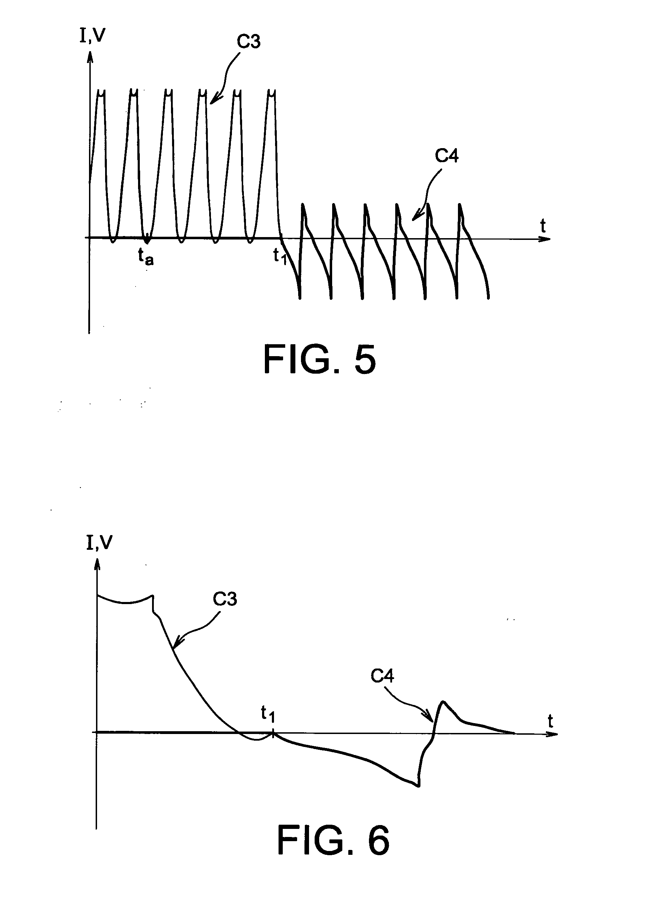

Les figures 5, 6 et 7A-7C illustrent le procédé d'ouverture d'un interrupteur de dérivation parcouru par un courant selon l'invention. La figure 6 est une vue zoomée de la figure 5. La courbe C3 sur les figures 5, 6 et 7A-7C représente le courant I qui parcourt l'interrupteur en fonction du temps et la courbe C4 sur les figures 5 et 6 représente la tension V aux bornes de l'interrupteur en fonction du temps.

La coupure du courant de l'interrupteur s'effectue lors d'un passage par zéro du courant qui parcourt l'interrupteur. Toutefois, selon l'invention, la valeur moyenne du courant qui parcourt l'interrupteur n'est ici pas nulle.

Le courant I qui parcourt l'interrupteur est mesuré par les moyens de mesure M et la mesure du courant I est transmsise à l'unité de contrôle correspondante. Sur la base de l'information de mesure du courant et de l'information relative à la dérivée du courant par rapport au temps, l'unité de contrôle délivre un signal qui modifie l'angle de contrôle du thyristor jusqu'à ce que le courant passe par zéro dans une zone où la dérivée par rapport au temps du courant mesuré est une fonction continue et où la valeur absolue de la valeur crête Iₘ du courant atteint sensiblement ou dépasse de peu la valeur absolue de l'imprécision de mesure du zéro de courant. La variation du courant en fonction du temps lors du passage par zéro prend alors une valeur parmi les plus faibles valeurs qu'il est possible d'atteindre et la tension de rétablissement aux bornes de l'interrupteur est également de faible valeur.

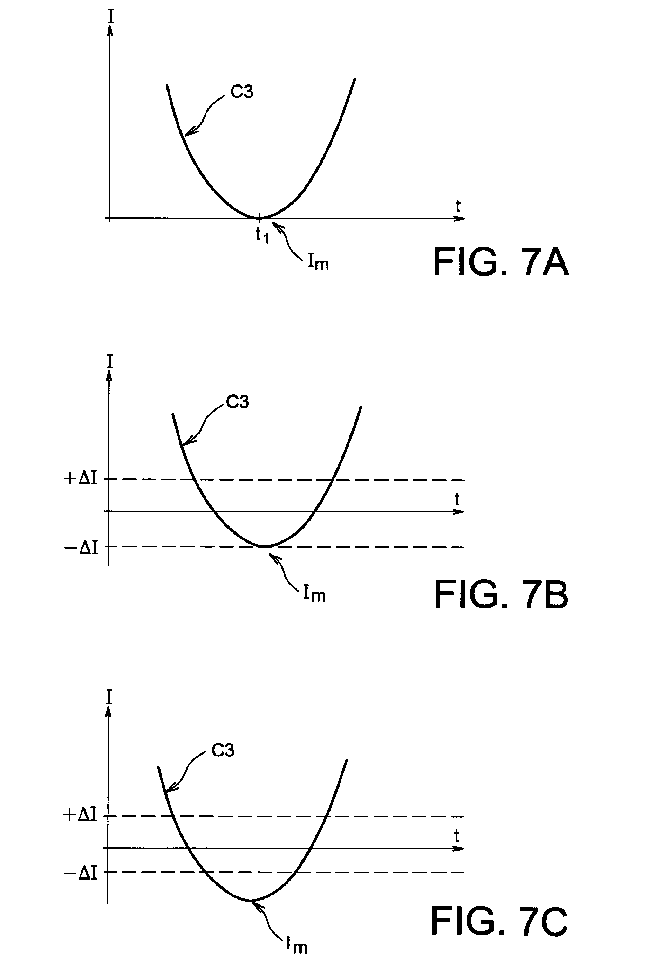

Les figures 7A-7C illustrent la zone de réglage dans laquelle le courant qui parcourt l'interrupteur est placé pour réaliser la coupure du courant selon l'invention. La figure 7A correspond au cas idéal où il n'y a pas d'imprécision de mesure du courant et les figures 7B-7C correspondent à deux cas réels où il y a des imprécisions de mesure.

Dans le cas idéal (figure 7A), la valeur crête Im du courant est nulle et la dérivée du courant au point de passage par zéro est également nulle à un instant t₁. La coupure du courant s'effectue alors à cet instant t₁.

Dans les cas réels où le courant instantané est mesuré avec une précision de ± ΔI, la condition sur le courant mentionnée ci-dessus se traduit par le fait que le courant minimal Iₘ est sensiblement égal (cf. figure 7B) ou faiblement inférieur (cf. figure 7C) à -ΔI. Il est alors assuré que le courant passe bien par zéro et que l'ouverture de l'interrupteur a bien lieu avec une faible surtension aux bornes de l'interrupteur.

Sur les figures 5, 6 et 7A-7C, le courant qui circule dans l'interrupteur a une valeur moyenne positive et le minimum de courant Iₘ a une valeur négative sensiblement égale à -ΔI. L'invention concerne également le cas (non représenté sur les figures) où le courant qui circule dans l'interrupteur est de sens opposé et a une valeur moyenne négative, le maximum de courant I_{M} ayant alors une valeur positive sensiblement égale à +ΔI.

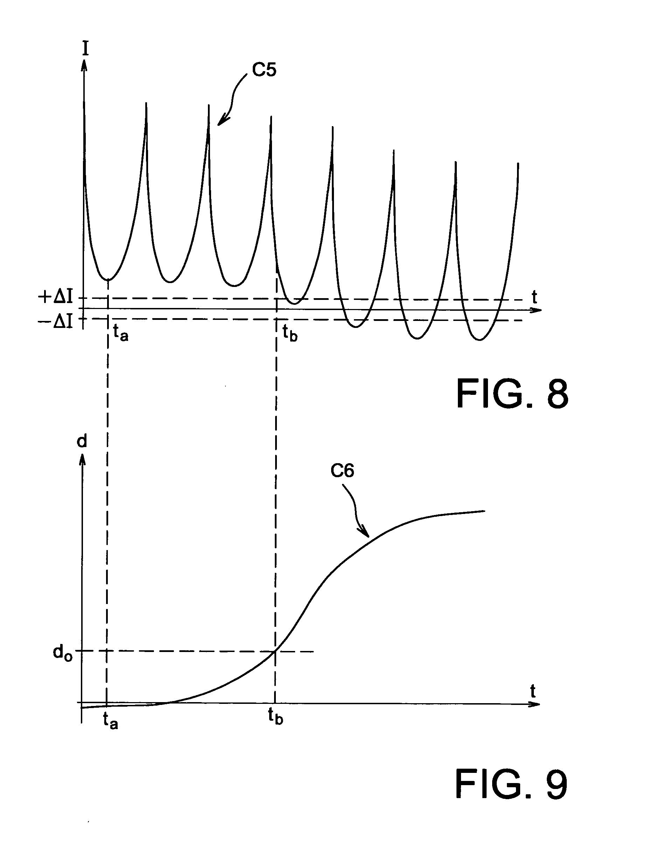

Les figures 8 et 9 illustrent un perfectionnement du procédé d'ouverture d'interrupteur de dérivation de l'invention. La courbe C5 de la figure 8 représente le courant I qui parcourt l'interrupteur de dérivation en fonction du temps. La courbe C6 de la figure 9 représente la distance d qui sépare les contacts de l'interrupteur de dérivation en fonction du temps.

Avant que ne soit donné l'ordre d'ouverture de l'interrupteur, la valeur instantanée du courant qui parcourt l'interrupteur ne présente pas de passage par zéro et sa valeur absolue reste toujours supérieure à la valeur du courant d'arrachement de l'interrupteur (« chopping current » en langue anglaise). L'ordre d'ouverture est alors donné à un instant tₐ. Dès que l'ordre d'ouverture est donné, la distance d qui sépare les contacts de l'interrupteur s'accroît et, simultanément, l'angle de contrôle est modifié pour rapprocher de zéro les minima de la courbe de courant. A un instant t_{b} ultérieur à tₐ, la distance qui sépare les contacts de l'interrupteur atteint une valeur d₀ considérée - a priori - comme susceptible de tenir la tension de rétablissement après la coupure du courant. A l'instant t_{b}, l'angle de contrôle est alors modifié pour que la valeur absolue du courant I atteigne des valeurs inférieures au courant d'arrachement, qu'il y ait des passages par zéro du courant et que la valeur minimale Iₘ du courant soit sensiblement égale ou légèrement inférieure à la précision de mesure -ΔI des moyens de mesure M. Le procédé d'ouverture se déroule ensuite sur la base de ce qui a été décrit précédemment.

Les moyens pour mettre en oeuvre le perfectionnement de l'invention comprennent soit un capteur de distance, soit un indicateur de dépassement de position, soit un mécanisme de temporisation. Dans le premier cas (capteur de distance), le capteur de distance mesure la distance qui sépare les contacts de l'interrupteur et l'instant t_{b} est l'instant où la distance mesurée atteint la valeur d₀, qui est alors une valeur prédéterminée. Dans le second cas (indicateur de dépassement de position), une pièce qui bouge au moment où les contacts se séparent donne un signal à l'instant t_{b} où la distance entre les contacts atteint la valeur d₀. Dans le troisième cas (mécanisme de temporisation), l'instant t_{b} résulte d'une temporisation mise en oeuvre par le mécanisme de temporisation. C'est alors l'instant t_{b} qui est une valeur prédéterminée et la valeur d₀ est la distance qui sépare les contacts de l'interrupteur lorsque l'instant t_{b} est atteint. La valeur t_{b} est alors obtenue à la suite de tests préliminaires pour assurer, dans tous les cas, une distance suffisante entre les contacts. Selon le perfectionnement de l'invention, l'ouverture de l'interrupteur se déroule alors avantageusement sans que ne puissent survenir des interruptions infructueuses de courant durant lesquelles sont susceptibles de survenir des claquages, lesquels sont toujours préjudiciables au bon fonctionnement du sytème.

De même que précédemment, pour les figures 5-6, le perfectionnement de l'invention est illustré, sur la figure 8, pour un courant dont la valeur moyenne est positive et pour lequel les minima de courant sont négatifs et ont une amplitude sensiblement égale à la précision de mesure du zéro de courant. Toutefois, le perfectionnement de l'invention concerne également le cas où le courant a une valeur moyenne négative et où les maxima de courant sont positifs et ont une amplitude sensiblement égale à la précision de mesure du zéro de courant.

On dira en conséquence, de façon générale, que les passages par zéro du courant qui parcourt l'interrupteur sont positionnés de façon telle que les valeurs crête du courant au-delà du zéro de courant sont sensiblement égales à l'imprécision de mesure du zéro de courant (±ΔI).

## Revendications

1. Procédé d'ouverture d'interrupteur de dérivation (8, 9, 10, 11) parcouru par un courant, l'interrupteur étant monté en parallèle d'au moins un thyrsitor (4, 5, 6, 7) de réseau à courant continu haute tension, une coupure du courant qui parcourt l'interrupteur étant déclenchée lors d'un zéro de courant du courant qui parcourt l'interrupteur, **caractérisé en ce qu'**il comprend, sur la base d'une mesure effectuée par des moyens de mesure (M) du courant qui parcourt l'interrupteur, une étape de réglage d'un angle de contrôle du thyristor pour positionner le zéro de courant dans une zone où la dérivée par rapport au temps du courant mesuré est une fonction continue et où la valeur absolue d'une valeur crête du courant mesuré est sensiblement égale à la valeur absolue de l'imprécision de mesure du zéro de courant.

2. Procédé selon la revendication 1, dans lequel, pendant une durée qui précède l'ouverture de l'interrupteur et durant laquelle le courant ne présente jamais de zéro de courant et a une valeur absolue qui reste supérieure à la valeur du courant d'arrachement de l'interrupteur, une commande d'ouverture est appliquée à l'interrupteur à un premier instant (tₐ) et, simultanément, une étape de réglage de l'angle de contrôle est déclenchée pour rapprocher de zéro des valeurs crête du courant de telle sorte qu'à un deuxième instant (t_{b}), ultérieur au premier instant, des contacts de l'interrupteur soient séparés d'une distance sensiblement prédéfinie (d₀) apte à permettre à l'interrupteur de tenir une tension de rétablissement.

3. Procédé selon la revendication 2, dans lequel une étape de mesure de la distance (d) qui sépare les contacts de l'interrupteur est déclenchée au premier instant (tₐ) et, au deuxième instant (t_{b}), une étape de réglage supplémentaire de l'angle de contrôle est déclenchée pour amener le courant dans la zone où la dérivée par rapport au temps du courant mesuré est une fonction continue et où la valeur absolue d'une valeur crête du courant mesuré est sensiblement égale à la valeur absolue de l'imprécision de mesure du zéro de courant.

4. Procédé selon la revendication 2, dans lequel le deuxième instant (t_{b}) est déclenché à l'aide d'un dispositif de temporisation et, au deuxième instant (t_{b}), une étape de réglage supplémentaire de l'angle de contrôle est déclenchée pour amener le courant dans la zone où la dérivée par rapport au temps du courant mesuré est une fonction continue et où la valeur absolue d'une valeur crête du courant mesuré est sensiblement égale à la valeur absolue de l'imprécision de mesure du zéro de courant.

5. Procédé selon la revendication 2, dans lequel le deuxième instant (t_{b}) est déclenché à l'aide d'un indicateur de dépassement de position lorsque la distance entre contacts atteint une distance sensiblement prédéfinie (d₀) et, au deuxième instant (t_{b}), une étape de réglage supplémentaire de l'angle de contrôle est déclenchée pour amener le courant dans la zone où la dérivée par rapport au temps du courant mesuré est une fonction continue et où la valeur absolue d'une valeur crête du courant mesuré est sensiblement égale à la valeur absolue de l'imprécision de mesure du zéro de courant.

## Patentansprüche

1. Verfahren zum Öffnen eines Bypass-Schalters (8, 9, 10, 11), der von einem Strom durchflossen wird, wobei der Schalter mit zumindest einem Thyristor (4, 5, 6, 7) für Hochspannungs-Gleichstromnetze parallel geschaltet ist, wobei eine Unterbrechung des den Schalter durchfließenden Stroms bei einem Nulldurchgang des den Schalter durchfließenden Stroms ausgelöst wird, **dadurch gekennzeichnet, dass** es auf Basis einer Messung, die durch Messeinrichtungen (M) zum Messen des den Schalter durchfließenden Stroms erfolgt, einen Schritt des Einstellens eines Kontrollwinkels des Thyristors umfasst, um den Nulldurchgang des Stroms in einen Bereich zu positionieren, wo die zeitliche Ableitung des gemessenen Stroms eine kontinuierliche Funktion ist und wo der absolute Wert eines Spitzenwerts des gemessenen Stroms im Wesentlichen gleich dem absoluten Wert der Messungenauigkeit des Nulldurchgangs des Stroms ist.

2. Verfahren nach Anspruch 1, wobei während einer Zeitdauer, die dem Öffnen des Schalters vorausgeht und in welcher der Strom niemals einen Nulldurchgang aufweist und einen absoluten Wert hat, der höher als der Wert des Abreissstroms des Schalters bleibt, dem Schalter zu einem ersten Zeitpunkt (tₐ) ein Öffnungsbefehl erteilt wird und zugleich ein Schritt des Einstellens des Kontrollwinkels ausgelöst wird, um Spitzenwerte des Stroms so an Null anzunähern, dass zu einem zweiten Zeitpunkt (t_{b}), der später als der erste Zeitpunkt liegt, Kontakte des Schalters um einen im Wesentlichen vorbestimmten Abstand (do) getrennt werden, der dazu geeignet ist, dem Schalter zu gestatten, eine wiederkehrende Spannung zu halten.

3. Verfahren nach Anspruch 2, wobei ein Schritt des Messens des Abstands (d), welcher die Kontakte des Schalters trennt, zum ersten Zeitpunkt (tₐ) ausgelöst wird und zum zweiten Zeitpunkt (t_{b}) ein zusätzlicher Schritt des Einstellens des Kontrollwinkels ausgelöst wird, um den Strom in den Bereich zu bringen wo die zeitliche Ableitung des gemessenen Stroms eine kontinuierliche Funktion ist und wo der absolute Wert eines Spitzenwerts des gemessenen Stroms im Wesentlichen gleich dem absoluten Wert der Messungenauigkeit des Nulldurchgangs ist.

4. Verfahren nach Anspruch 2, wobei der zweite Zeitpunkt (t_{b}) mit Hilfe einer Verzögerungsvorrichtung ausgelöst wird und zum zweiten Zeitpunkt (t_{b}) ein zusätzlicher Schritt des Einstellens des Kontrollwinkels ausgelöst wird, um den Strom in den Bereich zu bringen, wo die zeitliche Ableitung des gemessenen Stroms eine kontinuierliche Funktion ist und wo der absolute Wert eines Spitzenwerts des gemessenen Stroms im Wesentlichen gleich dem absoluten Wert der Messungenauigkeit des Nulldurchgangs ist.

5. Verfahren nach Anspruch 2, wobei der zweite Zeitpunkt (t_{b}) mit Hilfe eines Positionsüberschreitungsindikators dann ausgelöst wird, wenn der Abstand zwischen Kontakten einen im Wesentlichen vorbestimmten Abstand (do) erreicht, und zum zweiten Zeitpunkt (t_{b}) ein zusätzlicher Schritt des Einstellens des Kontrollwinkels ausgelöst wird, um den Strom in den Bereich zu bringen, wo die zeitliche Ableitung des gemessenen Stroms eine kontinuierliche Funktion ist und wo der absolute Wert eines Spitzenwerts des gemessenen Stroms im Wesentlichen gleich dem absoluten Wert der Messungenauigkeit des Nulldurchgangs ist.

## Claims

1. A method of opening a shunt switch (8, 9, 10, 11) carrying a current, the switch being connected in parallel with at least one thyristor (4, 5, 6, 7) of a high voltage DC network, interruption of the current flowing through the switch being initiated at the time of a current zero of the current flowing through the switch, the method being **characterized in that** it includes, based on a measurement effected by means (M) for measuring the current flowing through the switch, a step of adjusting a control angle of the thyristor to position the current zero in a zone in which the time derivative of the measured current is a continuous function and the absolute value of a peak value of the measured current is substantially equal to the absolute value of the inaccuracy of the measurement of the current zero.

2. A method according to claim 1, wherein, during a period that precedes opening of the switch and during which the current never includes a current zero and has an absolute value that remains greater than the value of the chopping current of the switch, an opening command is applied to the switch at a first time (tₐ) and a step of simultaneous adjustment of the control angle is initiated to move the peak values of the current closer to zero so that, at a second time (t_{b}) that is later than the first time, contacts of the switch are separated by a substantially predefined distance (do) enabling the switch to withstand a recovery voltage.

3. A method according to claim 2, wherein a step of measuring the distance (d) between the contacts of the switch is initiated at the first time (tₐ) and a step of additional adjustment of the control angle is initiated at the second time (t_{b}) to position the current in the zone in which the time derivative of the measured current is a continuous function and the absolute value of a peak value of the measured current is substantially equal to the absolute value of the inaccuracy of the measurement of the current zero.

4. A method according to claim 2, wherein the second time (t_{b}) is initiated by means of a timer device and at the second time (t_{b}) a step of additional adjustment of the control angle is initiated to position the current in the zone in which the time derivative of the measured current is a continuous function and the absolute value of a peak value of the measured current is substantially equal to the absolute value of the inaccuracy of the measurement of the current zero.

5. A method according to claim 2, wherein the second time (t_{b}) is initiated by means of a position overshoot indicator when the distance between contacts reaches a substantially predefined distance (do) and at the second time (t_{b}) a step of additional adjustment of the control angle is initiated to position the current in the zone in which the time derivative of the measured current is a continuous function and the absolute value of a peak value of the measured current is substantially equal to the absolute value of the inaccuracy of the measurement of the current zero.
